# FASCICULE DE BREVET EUROPEEN

(11) **EP 0 652 636 B1**
(45) Date de publication et mention de la délivrance du brevet: **06.05.1999**
(21) Numéro de dépôt: 94402467.8
(22) Date de dépôt: 02.11.1994
(51) Int. Cl.: H03F 3/217

(54) **Amplificateur de puissance du type pont en H et ses moyens de blocage**
H-Brückenleistungsverstärker und Einrichtung zum Schalter desselben
H-bridge type power amplifier and blocking means therefore

(30) Priorité: 05.11.1993 FR 9313177
(43) Date de publication de la demande: 10.05.1995
(73) Titulaire: THOMSON-CSF, 75008 Paris (FR)
(72) Inventeur: Gerfault, Bertrand, THOMSON-CSF, SCPI, F-92402 Courbevoie Cedex (FR)
(74) Mandataire: Courtellemont, Alain

(56) Documents cités:
- EP-A- 0 535 797
- DE-A- 1 911 109
- DE-C- 1 591 820
- FR-A- 1 414 293
- US-A- 4 366 441

## Description

La présente invention telle qu'elle est définie dans les revendications concerne les amplificateurs du type pont en H, et leurs moyens de blocage; elle concerne également les dispositifs amplificateurs de puissance à l'état solide comportant de tels amplificateurs.

Les amplificateurs de puissance, dits ponts en H ou ponts complets, sont souvent employés comme modules de puissance pour réaliser des dispositifs amplificateurs de puissance à l'état solide. Le document FR-A-1 414 293 divulgue un tel module de puissance. Dans ces dispositifs les charges des ponts en H sont constituées par les primaires de transformateurs dont les secondaires sont disposés en série. La modulation du signal d'entrée des dispositifs amplificateurs à ponts en H est obtenue en bloquant ou débloquant tout ou partie des ponts en H en fonction du signal porteur de l'information à transmettre. Parmi les moyens de blocage connus certains réalisent le blocage de façon autoritaire c'est-à-dire sans synchroniser le signal modulé et le signal modulant, il en résulte des contraintes importantes: commutation avec courant, discontinuité de phase...

Avec d'autres moyens de blocage connus, une synchronisation des signaux est prévue qui nécessite des détections de phase, une synchronisation par bascule de type D puis une amplification. Il en résulte un nombre important de composants et, de plus, les circuits logiques mis en oeuvre s'accommodent mal de la présence, dans leurs voisinage immédiat, des circuits de puissance.

Le but de l'invention est d'éviter ou, pour le moins, de réduire ces inconvénients.

Ceci est obtenu en utilisant directement le signal d'entrée du dispositif amplificateur à ponts en H pour autoriser ou non le blocage ou le déblocage des ponts en H.

Selon l'invention ceci est mis en oeuvre par un amplificateur de puissance tel que décrit, en particulier, dans la revendication 1.

La présente invention sera mieux comprise et d'autres caractéristiques apparaîtront à l'aide de la description ci-après et des figures s'y rapportant qui représentent :
- la figure 1, un dispositif amplificateur de puissance à l'état solide auquel peuvent être associés des moyens de blocage de ponts en H selon l'invention,
- les figures 2 et 4, des schémas relatifs à des moyens de blocage d'amplificateurs de puissance selon l'invention,
- les figure 3 et 5, des chronogrammes relatifs respectivement aux schémas des figures 2 et 4.

Sur les différentes figures les éléments correspondants sont désignés par les mêmes repères.

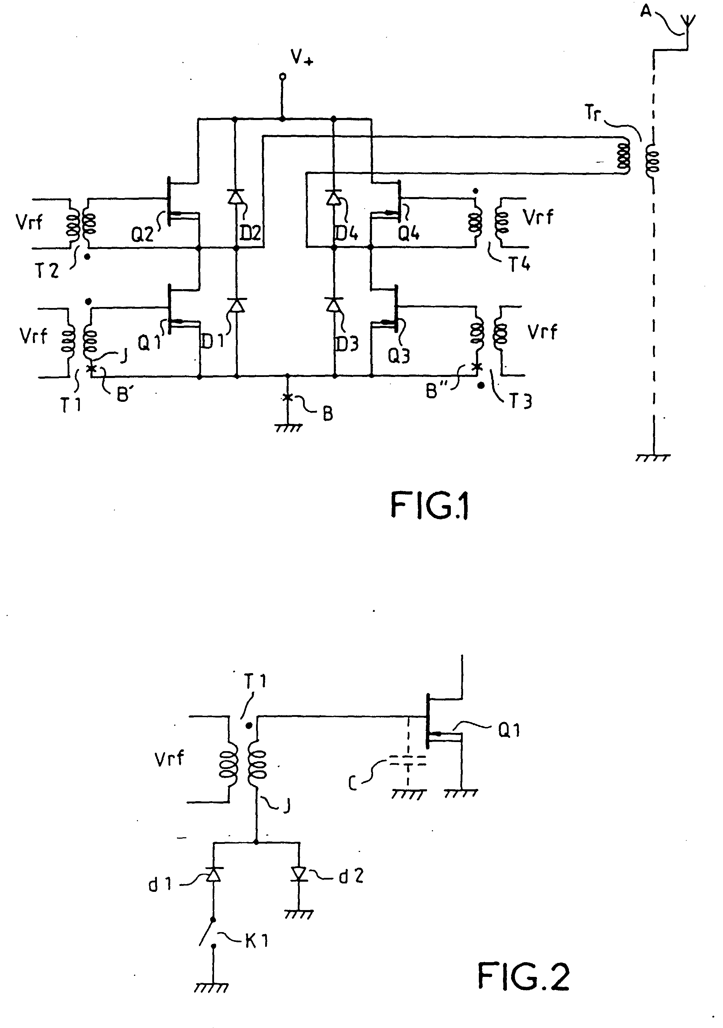

La figure 1 est le schéma simplifié d'un dispositif amplificateur de puissance fait de modules de puissance du type ponts en H, dont les charges sont constituées par des transformateurs, Tr, à secondaires disposés en série entre la masse et une antenne d'émission, A ; un seul de ces modules a été dessiné sur la figure 1. Le nombre de modules que comporte un dispositif amplificateur est généralement nettement supérieur à cent ; les modules d'un même dispositif peuvent être tous strictement identiques ou bien tous identiques à l'exception d'un petit nombre d'entre eux présentant des puissances plus faibles de manière à pouvoir fournir à l'antenne des puissances finement réglables par combinaisons de modules à puissances de sorties diverses. Toutefois les modules étant réalisés de manière semblable, même pour des puissances différentes, la description d'un seul d'entre eux suffit à expliquer leur fonctionnement. Chacun de ces modules reçoit un même signal d'entrée à radio-fréquence, Vrf. Par une commande fonction d'un signal d'information à transmettre, tout ou partie des modules du dispositif est bloqué, ce qui entraîne, pour le signal Vrf, une modulation et une amplification avant transmission à l'antenne.

Le module amplificateur pont en H représenté sur la figure 1 comporte quatre transistors MOSFET canal N identiques, Q1 à Q4, montés par paires Q1-Q2, Q3-Q4 entre la masse et une source de tension continue V+ : les sources de Q1 et Q3 sont reliées à la masse, les drains de Q1 et Q3 sont reliés respectivement aux sources de Q2 et de Q4 et les drains de Q2 et Q4 sont reliés à la source de tension continue V+. Entre la source et la grille des transistors Q1 à Q4 sont respectivement branchés les secondaires de quatre transformateurs T1 à T4 qui reçoivent sur leur primaire le signal d'entrée Vrf; les transistors Q1, Q4 reçoivent le signal Vrf avec la même amplitude et la même phase et les transistors Q2, Q3 reçoivent le signal Vrf avec la même amplitude que pour Q1, Q4 mais en opposition de phase par rapport au signal reçu par Q1, Q4. Quatre diodes D1 à D4 sont respectivement associées aux transistors Q1 à Q4 avec leur anode et leur cathode respectivement reliées à la source et au drain du transistor auquel elles sont associées.

Les transistors du montage selon la figure 1 fonctionnent en régime de commutation, les transistors Q1 et Q4 amplifiant l'une des alternances du signal Vrf pendant que les transistors Q2, Q3 sont bloqués et inversement pour l'alternance suivante.

La modulation du signal Vrf se fait en agissant sur le fonctionnement des transistors MOSFET; les moyens de blocage sont généralement constitués par un circuit de commande, B, inséré entre le point commun aux sources des transistors Q1, Q3 et la masse ; la modulation peut aussi être obtenue, par exemple, à l'aide de moyens de blocage constitués de deux circuits de commande, B', B'', insérés, l'un entre la source de Q1 et la borne J du secondaire de T1 opposée à la grille de Q1 et l'autre entre la source de Q3 et la borne du secondaire de T3 opposée à la grille de Q3 ; les endroits où, soit le circuit de commande unique B, soit les deux circuits de commande, B', B'', sont insérés, ont été symbolisés par des croix sur la figure 1.

Les commandes arrêt-marche B' et B'' sont deux commandes identiques recevant les mêmes signaux, aussi comme, dans la suite de la description, les moyens de blocage seront du type B', B'', seul le circuit B' sera décrit.

Il est à noter, pour bien comprendre les moyens de blocage qui vont être décrits ci-après, d'une part que le courant dans la charge d'un pont en H d'un dispositif amplificateur de puissance, comme celui de la figure 1, est imposé par l'ensemble des ponts en H du dispositif qui sont débloqués et d'autre part que le primaire du transformateur de charge Tr de chaque pont en H du dispositif ne doit jamais être en circuit ouvert afin de ne pas ramener une impédance infinie dans la liaison antenne-masse selon la figure 1.

Dans ce qui suit il sera question d'état normal et d'état bloqué d'un pont en H équipé des moyens de blocage B' B'' ; l'état bloqué sera celui où le pont en H ne fournit pas de puissance de sortie du fait du blocage réalisé à l'aide des moyens de blocage B', B'' et l'état normal sera celui où, les moyens de blocage B', B'' se comportant comme deux courts-circuits, le pont en H selon la figure 1 amplifie "normalement" le signal Vrf. Bien entendu c'est au passage d'un état à l'autre que des problèmes risquent de se poser ; la suite de la description montrera comment de tels problèmes peuvent être évités.

La figure 2 est un schéma simplifié et partiel du circuit de commande B' de la figure 1, tel qu'il peut être réalisé selon l'invention. Ce circuit de commande comporte, vu de la borne J du secondaire de T1 opposée à la grille de Q1, une première diode, d1, dans le sens bloqué, reliée à la masse par un interrupteur K1 et une seconde diode, d2, dans le sens passant et dont la cathode est directement reliée à la masse.

Le fonctionnement du circuit de commande selon la figure 2 fait intervenir la capacité interne de grille du transistor MOSFET Q1 ; cette capacité est représentée par un condensateur C sur la figure 2. Dans le cas où le pont en H selon la figure 1 serait constitué de transistors bipolaires il faudrait, pour retrouver les mêmes conditions de fonctionnement qu'avec des transistors MOSFET, soit utiliser des transistors bipolaires Q1, Q3 à entrée MOS, soit brancher un condensateur entre la masse et la grille des transistors Q1, Q3. Le circuit de commande de la figure 2 utilise l'effet de mémoire que donne au transistor Q1 sa capacité interne de grille.

Avec l'interrupteur K1 fermé, le pont en H est dans l'état normal, la diode d1 conduisant pendant la charge du condensateur C et la diode d2 conduisant pendant sa décharge.

A l'ouverture de l'interrupteur K1 deux cas sont à considérer en fonction du signal d'entrée Vrf du pont en H: soit la tension aux bornes du secondaire du transformateur T1 est négative, soit elle est positive. Si cette tension est négative, alors le transistor Q1 est bloqué et, du fait que l'interrupteur K1 est ouvert comme représenté sur la figure 2, le condensateur C reste chargé à une tension négative constante et le transistor Q1 reste bloqué. Si, au moment de l'ouverture de l'interrupteur K1, la tension est positive aux bornes du secondaire du transformateur T1, la tension aux bornes du condensateur C est positive et, tant qu'elle reste positive, le transistor Q1 est passant; lorsque la tension positive aux bornes du secondaire du transformateur T1, du fait du signal Vrf, décroît, le condensateur C se décharge à travers la diode d2 pour se charger négativement et bloquer Q1 dès que la tension aux bornes du secondaire du transformateur T1 devient négative; le transistor Q1 reste alors bloqué, le condensateur C, chargé négativement, ne pouvant se décharger à travers d1 tant que K1 reste ouvert.

Ainsi le transistor Q1 est maintenu passant tant que la tension aux bornes du secondaire du transformateur T1 est positive afin que le blocage du transistor Q1 et, corrélativement, du pont en H se trouvent synchronisées avec le signal d'entrée Vrf : soit la tension sur la grille du transistor Q1 est négative alors Q1 est bloqué au moment de l'ouverture de l'interrupteur K1 et reste bloqué ensuite, soit cette tension est positive et le transistor Q2 reste passant jusqu'à ce que la tension d'entrée Vrf change de signe.

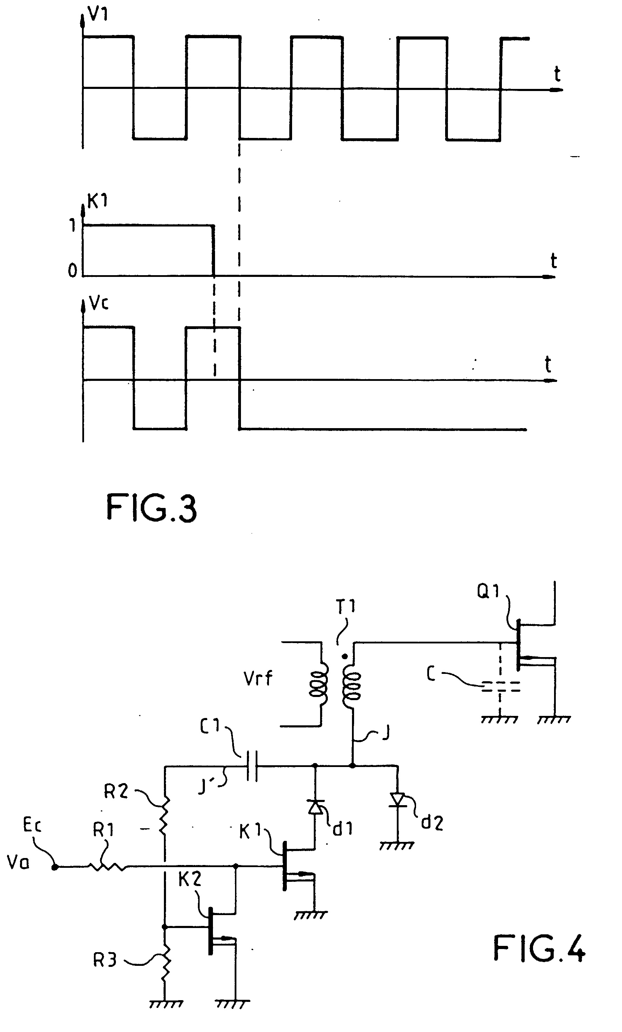

Le cas où la tension aux bornes du secondaire du transformateur T1 est positive au moment de l'ouverture de l'interrupteur K1, est illustré par la figure 3 qui représente sur un même chronogramme la tension V1 aux bornes du secondaire du transformateur T1, les états fermé, 1, ouvert, 0, de l'interrupteur K1 et la tension Vc aux bornes du condensateur C.

La commande de blocage n'entraîne, comme il a été vu précédemment, le blocage du transistor Q1 que lorsque la tension aux bornes du secondaire de T1 est négative. Quant à la commande de déblocage du transistor Q1 pour passer à l'état normal du pont en H, elle va devoir se faire uniquement lorsque la tension aux bornes du transformateur T1 sera négative afin d'éviter une commutation du transistor Q1 au moment où, la tension sur sa grille étant positive, il jouerait immédiatement son rôle d'amplificateur et il n'y aurait donc pas de synchronisme.

La figure 4 est un schéma électronique montrant des moyens de blocage satisfaisant aux critères énoncés dans le paragraphe précédent.

La figure 4 correspond à la figure 2 complétée pour assurer un déblocage en synchronisme avec le signal, Vrf, d'entrée du pont en H, et modifiée pour y faire figurer, comme interrupteur K1, non pas un simple contact mais un interrupteur électronique fait d'un transistor MOSFET canal P. Le drain du transistor K1 est relié à l'anode de la diode d1, sa source est reliée à la masse et sa grille est couplée, à travers une résistance R1, à l'entrée de commande Ec du montage. Sur cette entrée est appliqué un signal Va qui peut présenter deux valeurs, 0 et -V, selon que le pont en H doit être dans l'état bloqué ou dans l'état normal.

Le montage selon la figure 4 comporte de plus un transistor MOSFET canal P, K2, deux résistances R2, R3 et un condensateur C1. Le drain du transistor K2 est relié à la grille du transistor K1 tandis que sa source est reliée à la masse. L'une des bornes du condensateur C1 est reliée à la borne J du secondaire du transformateur T1 ; l'autre borne, J', du condensateur C1 est reliée, à travers la résistance R2, à la grille du transistor K2 et cette grille est reliée à la masse par la résistance R3.

Le rôle du montage selon la figure 4 est de maintenir bloqué le transistor K1 tant que la tension sur le secondaire du transformateur T1 est positive c'est-à-dire tant que la tension sur les bornes J et J' est négative ; tant que c'est le cas la tension qui s'applique sur la grille du transistor K2 est négative ; ce transistor est donc passant et met à la masse la grille du transistor K1 ; de ce fait K1 se trouve bloqué même si le signal de commande Va sur l'entrée Ec est à la valeur -V.

Par contre si la tension sur le secondaire du transformateur T1 est négative, ce qui correspond à une tension positive sur les bornes J et J', alors une tension positive s'applique sur la grille du transistor K2. Ce transistor est donc bloqué, ce qui autorise le passage à l'état passant du transistor K1 lorsque le signal de commande sur l'entrée Ec est à la valeur -V correspondant à une commande de passage à l'état normal du pont en H ; et, le transistor K1 étant passant, d'une part le transistor Q1 est débloqué et d'autre part la tension en J et J' s'annule ce qui bloque le transistor K2 et verrouille le fonctionnement dans l'état normal aussi longtemps que le signal de commande est à -V.

Le transistor K2 ne modifie pas le fonctionnement pour le passage à l'état bloqué tel qu'il a été expliqué à l'aide de la figure 2 ; en effet lorsque le signal de commande d'état bloqué, constitué par un niveau O, est appliqué sur l'entrée de commande Ec, une tension de niveau O est immédiatement appliquée sur la grille du transistor K1, bloquant ce transistor et cela aussi bien si le transistor K2 est passant que s'il est bloqué.

Il est à noter que le rôle du condensateur C1 est d'éviter qu'une petite tension parasite positive sur la borne J puisse entraîner un passage indésiré de l'état bloqué à l'état normal : grâce au condensateur C1 la tension sur la borne J' est la valeur moyenne de la tension sur la borne J et les parasites sont donc éliminés.

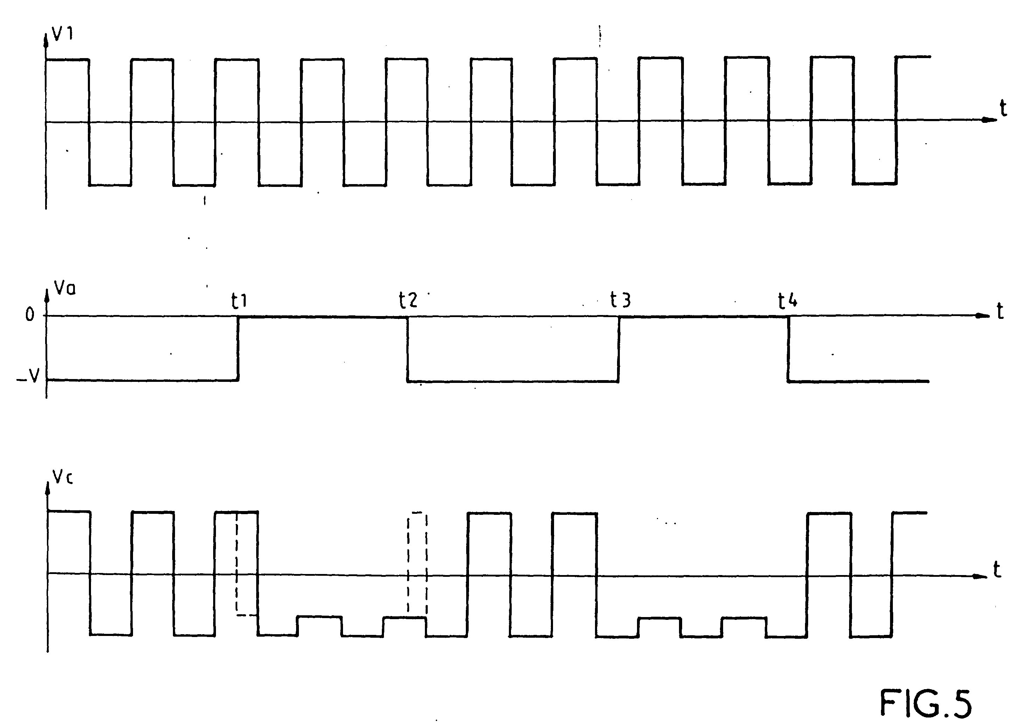

La figure 5 est un chronogramme correspondant à celui de la figure 3 mais dans lequel
- l'état de l'interrupteur K1 a été remplacé par le signal de commande Va sur l'entrée de commande Ec,
- il a été tenu compte des courants de fuite dans la représentation de la tension Vc aux bornes du condensateur C,
- quatre cas de commande du pont en H ont été représentés avec, en plus, en traits interrompus sur le chronogramme de Vc, l'allure de la courbe s'il n'y avait pas synchronisation du blocage et du déblocage avec la tension V1 aux bornes du secondaire du transformateur T1 et donc avec la tension Vrf d'entrée du pont en H.

Ces quatre cas de commande du pont en H sont :
- en t1, le déclenchement d'un état bloqué alors que la tension V1 aux bornes du secondaire du transformateur T1 est positive ; le blocage effectif du transistor Q1 attend, pour se produire, que la tension V1 devienne négative,
- en t2, le déclenchement d'un état normal alors que la tension V1 est positive ; le déblocage effectif du transistor Q1 attend, pour se produire, que la tension V1 devienne positive,
- en t3 et t4, le déclenchement respectivement d'un état bloqué et d'un état normal alors que la tension V1 aux bornes du transformateur T1 est négative ; le transistor Q1 étant bloqué par les tensions V1 négatives, la synchronisation ne pose pas de problème le transistor restant bloqué après t3 et se débloquant, après t4, dès que la tension V1 devient positive.

La présente invention n'est pas limitée à l'exemple de réalisation qui vient d'être décrit ; elle s'applique d'une façon plus générale à des ponts en H où les moyens de blocage comportent, pour chaque branche verticale du pont en H
- un premier interrupteur, en parallèle sur un élément semi-conducteur, couplé, d'un côté, à travers un secondaire de transformateur du pont en H, à l'électrode de commande d'un des quatre transistors du pont en H et, de l'autre côté, à un potentiel donné de mise dans l'état passant du transistor considéré, l'électrode de commande étant de plus couplée au potentiel donné par un élément capacitif,
- un second interrupteur commandé en fonction du signal aux bornes du secondaire considéré, pour maintenir ouvert le premier interrupteur quand le sens de ce signal est un sens donné.

## Revendications

1. Amplificateur de puissance du type pont en H et ses moyens de blocage, l'amplificateur comportant quatre transistors (Q1-Q4), constituant chacun une branche du pont une entrée de blocage (Ec) et quatre transformateurs (T1-T4), associés respectivement aux quatre transistors de manière à les commander individuellement, avec chacun un enroulement secondaire ayant une première borne reliée à une électrode de commande du transistor associé et une seconde borne (J), deux de ces secondes bornes étant des bornes de blocage couplées par les moyens de blocage à un même point à potentiel fixe, caractérisé en ce que les moyens de blocage comportent, d'une part, connecté entre chacune des deux bornes de blocage et le point à potentiel fixe, un premier interrupteur (K1, d1) et un élément semi-conducteur (d2) montés en parallèle, chaque premier interrupteur ayant une entrée de commande couplé à l'entrée de blocage (Ec), et, d'autre part, associé à chaque premier interrupteur, un second interrupteur (K2), couplé à l'entrée de commande du premier interrupteur qui lui est associé, ce second interrupteur ayant une entrée de commande couplée à celle (J) des bornes de blocage à laquelle est connecté le premier interrupteur qui lui est associé.

2. Amplificateur selon la revendication 1, caractérisé en ce que les transistors sont des transistors MOSFET.

3. Amplificateur selon l'une des revendications précédentes, caractérisé en ce que le premier interrupteur est constitué par le montage en série d'un transistor supplémentaire (K1) et d'une diode (d1) et en ce que l'entrée de commande du premier interrupteur est constituée par une des électrodes du transistor supplémentaire.

4. Amplificateur selon la revendication 3, caractérisé en ce que le second interrupteur est un transistor (K2) dont les trois électrodes sont, pour deux d'entre elles, en série entre l'entrée de commande du premier interrupteur (K1, d1) et le point à potentiel fixe et, pour la troisième d'entre elles, l'entrée de commande du second interrupteur.

5. Dispositif amplificateur de puissance, caractérisé en ce qu'il comporte au moins deux amplificateurs avec leurs moyens de blocage selon l'une des revendications précédentes.

## Patentansprüche

1. Leistungsverstärker des H-Brückentyps und dessen Sperrmittel, wobei der Verstärker vier Transitoren (Q1-Q4), die jeweils einen Zweig der Brücke bilden, einen Sperreingang (Ec) und vier Transformatoren (T1-T4) enthält, die den vier Transistoren jeweils in der Weise zugeordnet sind, daß sie diese einzeln steuern, wobei jeder eine Sekundärwicklung mit einem ersten Anschluß, der mit einer Steuerelektrode des zugeordneten Transistors verbunden ist, und einem zweiten Anschluß (J) besitzt, wobei zwei dieser zweiten Anschlüsse Sperranschlüsse sind, die durch die Sperrmittel an ein und demselben Punkt mit festem Potential angeschlossen sind, dadurch gekennzeichnet, daß die Sperrmittel einerseits einen zwischen jeden der beiden Sperranschlüsse und den Punkt mit festem Potential geschalteten ersten Ein/Aus-Schalter (K1, d1) und ein Halbleiterelement (d2), die parallelgeschaltet sind, wobei jeder erste EIN/AUS-Schalter einen an den Sperreingang (Ec) angeschlossenen Steuereingang besitzt, und andererseits einen jedem ersten EIN/AUS-Schalter zugeordneten zweiten EIN/AUS-Schalter (K2), der an den Steuereingang des ihm zugeordneten ersten EIN/AUS-Schalters angeschlossen ist, enthalten, wobei dieser zweite EIN/AUS-Schalter einen Steuereingang besitzt, der an denjenigen (J) der Sperranschlüsse gekoppelt ist, an den der ihm zugeordnete erste EIN/AUS-Schalter angeschlossen ist.

2. Verstärker nach Anschluß 1, dadurch gekennzeichnet, daß die Transistoren MOSFET-Transistoren sind.

3. Verstärker nach irgendeinem der vorangehenden Ansprüche, dadurch gekennzeichnet, daß der erste EIN/AUS-Schalter durch eine Serienschaltung aus einem zusätzlichen Transistor (K1) und einer Diode (d1) gebildet ist und daß der Steuereingang des ersten EIN/AUS-Schalters durch eine der Elektroden des zusätzlichen Transistors gebildet ist.

4. Verstärker nach Anspruch 3, dadurch gekennzeichnet, daß der zweite EIN/AUS-Schalter ein Transistor (K2) ist, wovon zwei der drei Elektroden zwischen den Steuereingang des ersten EIN/AUS-Schalters (K1, d1) und den Punkt mit festem Potential in Serie geschaltet sind und wovon die dritte der Steuereingang des zweiten EIN/AUS-Schalters ist.

5. Leistungsverstärkervorrichtung, dadurch gekennzeichnet, daß sie wenigstens zwei Verstärker mit ihren Sperrmitteln nach einem der vorangehenden Ansprüche enthält.

## Claims

1. Power amplifier of the H-bridge type and its blocking means, the amplifier having four transistors (Q1-Q4), each constituting one branch of the bridge, a blocking input (Ec) and four transformers (T1-T4) which are associated respectively with the four transistors so as to control them individually, each with a secondary winding having a first terminal connected to a control electrode of the associated transistor and a second terminal (J), two of these second terminals being blocking terminals coupled by the blocking means to one and the same fixed-potential point, characterized in that the blocking means include, on the one hand, connected between each of the two blocking terminals and the fixed-potential point, a first switch (K1, d1) and a semiconductor element (d2) which are connected in parallel, each first switch having a control input coupled to the blocking input (Ec) and, on the other hand, associated with each first switch, a second switch (K2) coupled to the control input of the first switch which is associated with it, this second switch having a control input coupled to that (J) of the blocking terminals to which the first switch which is associated with it is connected.

2. Amplifier according to Claim 1, characterized in that the transistors are MOSFET transistors.

3. Amplifier according to one of the preceding claims, characterized in that the first switch consists of the series connection of an additional transistor (K1) and a diode (d1), and in that the control input of the first switch consists of one of the electrodes of the additional transistor.

4. Amplifier according to Claim 3, characterized in that the second switch is a transistor (K2) whose three electrodes are, as regards two of them, in series between the control input of the first switch (K1, d1) and the fixed-potential point and, as regards the third of them, the control input of the second switch.

5. Power amplifier device, characterized in that it has at least two amplifiers with their blocking means according to one of the preceding claims.
